# FASCICULE DE BREVET EUROPEEN

(11) **EP 1 624 460 B1**
(45) Date de publication et mention de la délivrance du brevet: **03.06.2009**
(21) Numéro de dépôt: 05366006.4
(22) Date de dépôt: 28.07.2005
(51) Int. Cl.: G11C 11/41

(54) **Mémoire comprenant un point mémoire de type SRAM, procédé de lecture et procédé d'écriture associés.**
Speicher mit einem Speicherpunkt vom SRAM-Typ, dazugehörige Lese-und Schreibverfahren
Memory comprising a SRAM-type memory element, associated reading method and writing method

(30) Priorité: 04.08.2004 FR 0408605
(43) Date de publication de la demande: 08.02.2006
(73) Titulaire: STMicroelectronics SA, 92120 Montrouge (FR)
(72) Inventeur: Genevaux Franck c/o Novagraaf technologies, 57070 Metz (FR)
(74) Mandataire: Bouchet, Geneviève

(56) Documents cités:
- WO-A-20/04049348
- US-A- 4 956 815
- US-A1- 2004 047 176
- US-B1- 6 198 656

## Description

Dans le domaine des mémoires de type SRAM, l'invention concerne plus particulièrement une mémoire comportant une rangée comprenant un ensemble de points mémoire, chaque point mémoire comprenant un premier inverseur IA et un deuxième inverseur IB connectés tête-bêche entre un premier noeud A et un deuxième noeud B, et un premier transistor d'accès TA dont un drain est connecté au premier noeud A, dont une grille est connectée à une ligne de mot WL et dont une source est connectée à une ligne de bit BLT.

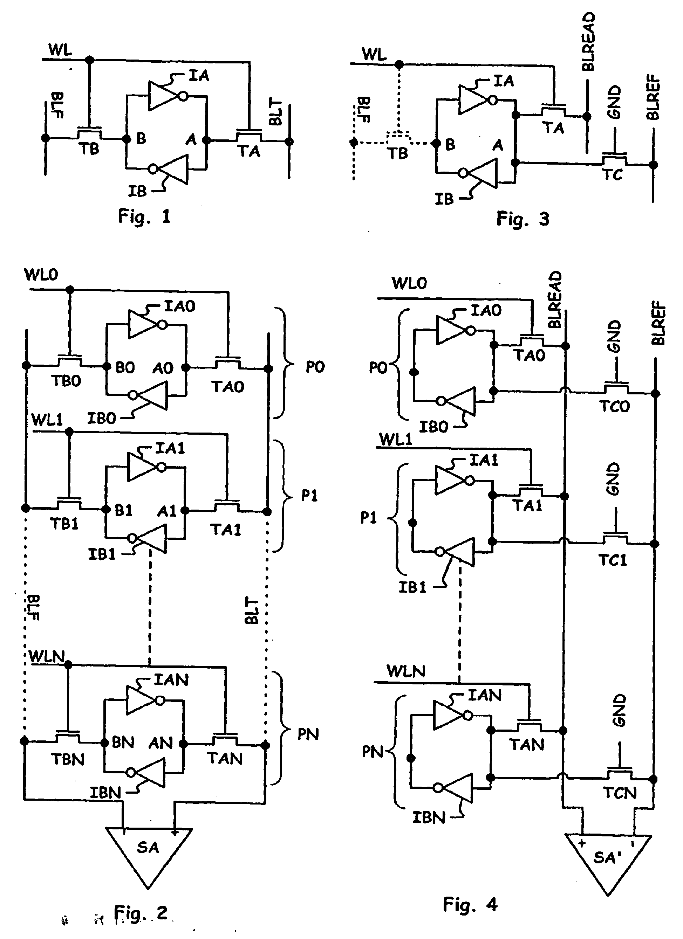

Un point mémoire connu est représenté sur la figure 1. Il comprend également un deuxième transistor d'accès TB dont un drain est connecté au deuxième noeud B, dont une grille est connectée à la ligne de mot WL et dont une source est connectée à une deuxième ligne de bit BLF.

Sur la figure 2 sont représentés N+1 points mémoire P0, P1, ..., PN tels que décrits ci-dessus, associés pour former une rangée d'une mémoire SRAM connue, ladite rangée comprenant également un amplificateur différentiel de lecture SA. Tous les points P0, P1, ..., PN sont connectés aux mêmes lignes de bit BLF et BLT. Par contre, chaque point est connecté à une ligne de mot différente WL0, WL1, ..., WLN. L'amplificateur SA est un amplificateur différentiel en potentiel, symétrique ; il comprend deux entrées différentielles connectées respectivement à la première ligne de bit et à la deuxième ligne de bit.

Pour programmer un point mémoire de la rangée de points, on applique un potentiel VDD sur la ligne de mot WL associée au point à programmer, et selon la donnée 0 ou 1 à programmer dans le point mémoire, on applique un potentiel nul (connexion à la masse) ou le potentiel VDD sur la première ligne de bit BLT, et on applique sur la deuxième ligne BLF un potentiel inverse du potentiel appliqué sur la ligne BLT. Dans un exemple, pour programmer un 0 logique dans le point P0, on applique VDD sur les lignes WL0, BLF et on connecte la ligne BLT à la masse. Après programmation d'un 0, le point A est au potentiel nul et le point B est au potentiel VDD.

Pour lire le contenu d'un point mémoire, par exemple le point P0 sur la figure 2, on précharge tout d'abord les deux lignes de bits BLF et BLT à un potentiel d'alimentation VDD. Puis, on applique le potentiel VDD sur la ligne de mot WL0 correspondant (WL0 = 1 logique) pour sélectionner le point P0 (les autres lignes de mots sont connectés à la masse : WL1 = ... = WLN = 0) et on rend flottantes les deux lignes de bit BLF et BLT. Comme la ligne WL0 est au potentiel VDD, les transistors d'accès TA0, TB0 du point mémoire P0 sont passants. De plus, comme le noeud A0 du point P0 est à 0 et la ligne BLT est au potentiel VDD, les deux côtés du canal du transistor TA0 sont à des potentiels différents, de sorte qu'un courant IREAD circule dans ce canal. Ce courant IREAD va décharger la ligne BLT et ramener ainsi progressivement son potentiel à 0. Par contre, comme le noeud B0 du point P0 et la ligne BLF sont au même potentiel VDD, les deux côtés du canal du transistor TB0 sont au même potentiel et aucun courant ne circule dans ce canal. La ligne BLF reste au potentiel VDD. Au bout d'un certain temps, l'amplificateur SA détecte en principe une différence de potentiel entre les lignes BLT, BLF, et produit en conséquence une donnée correspondant à la donnée mémorisée dans le point mémoire, c'est-à-dire :
- un 0 logique si le potentiel sur la ligne BLF est supérieur au potentiel sur la ligne BLT (c'est le cas du point P0 figure 1),
- un 1 sinon.

La lecture n'est ainsi possible que si une différence de potentiel d'amplitude suffisante apparaît entre les lignes BLT et BLF. Or, à cause de fuites inhérentes aux transistors d'accès TA, TB des points mémoire de la rangée, il est possible que cette différence de potentiel ne soit jamais suffisante, de sorte qu'il n'est pas possible de lire correctement un point.

En effet, même correctement bloqué par un potentiel approprié appliqué sur sa grille, un transistor présente des fuites lorsqu'une différence de potentiel apparaît entre son drain et sa source. Dans l'exemple de la figure 2, on suppose que dans les points P1, ..., PN sont mémorisés des 1 logiques : les noeuds A1, ..., AN sont ainsi à 1 et les noeuds B1, ..., BN sont à 0. Le point P0 étant sélectionné (WL0 = 1, les transistors TB1, TBN sont bloqués (WL1 = 0, WLN = 0) ; malgré cela, des courants de fuite IOFF1, ..., IOFFN s'établissent entre le drain et la source des transistors TB1, ..., TBN. Ces courants IOFF sont liés à la différence de potentiel entre la ligne BLF et les points TB1, ..., TBN, et aux fuites inhérentes aux transistors TB1, TBN. Ils sont identiques si les transistors TB1, TBN sont identiques. Ils vont ensemble décharger progressivement le potentiel de la ligne BLF. Dans l'hypothèse la plus défavorable, si tous les points P1, ..., PN mémorisent un 1 logique, alors un courant égal à N*IOFF décharge le potentiel de la ligne BLF. On comprend aisément que si le courant N*IOFF est voisin du courant IREAD, les deux lignes BLT et BLF vont se de décharger simultanément et selon une pente voisine de sorte que la différence de potentiel entre ces deux lignes ne sera jamais assez importante pour permettre une lecture correcte du contenu du point mémoire P0.

On constate dans la pratique qu'on doit avoir IREAD /(N*IOFF) supérieur à 5 pour pouvoir lire correctement un point de la rangée de N points mémoire. Comme le courant IOFF ne peut être limité (il est inhérent aux transistors d'accès), il est nécessaire de limiter le nombre N de points associés à un même amplificateur de lecture SA pour pouvoir garantir une lecture correcte du contenu des points mémoire. Il est en conséquence nécessaire soit de limiter le nombre total de points mémoire d'une mémoire SRAM (ce qui limite évidemment sa capacité), soit d'ajouter des amplificateurs de lecture, ce qui entraîne une augmentation de la taille (en terme de surface et de volume de silicium occupé) de la mémoire. A titre indicatif, pour certaines mémoires, N est limité à 128.

Le document de l'art antérieur US 4 956 815 décrit un point mémoire SRAM comprenant un transistor de référence.

L'invention a pour but de proposer une mémoire SRAM associée, dans laquelle l'influence des courants de fuite est neutralisée, de sorte qu'ils ne viennent plus perturber la lecture d'un point mémoire.

Cet objectif est atteint avec une mémoire selon la revendication 1.

Comme on le verra mieux par la suite, l'utilisation d'un transistor de référence, connecté de manière similaire au transistor d'accès utilisé pour la lecture du point mémoire permet, lors de la lecture du point mémoire, de soustraire dans l'amplificateur de lecture la contribution apportée par les éventuels fuites de courant dans les transistors d'accès des autres points d'une même rangée. Il s'ensuit que les éventuelles fuites de courant ne perturbent plus la lecture d'un point mémoire, comme on le verra mieux par la suite dans des exemples.

Le potentiel de blocage utilisé est soit un potentiel de masse (potentiel nul), soit le potentiel d'alimentation VDD, selon le type de transistor choisi, N ou P, pour réaliser le transistor de référence.

Selon un mode de réalisation, la mémoire selon l'invention est complété par un moyen pour appliquer sur la ligne de mot (WL) un potentiel actif qui est :
- soit (VDD+VT) supérieur à un potentiel d'alimentation (VDD), si le premier transistor d'accès est d'un premier type (type N),
- soit (- VT) inférieur à un potentiel de masse (GND), si le premier transistor d'accès est d'un deuxième type (type P).

Ceci permet de garantir une programmation correcte du point mémoire, quelle que doit la valeur 0 ou 1 à mémoriser, comme on le verra mieux par la suite.

Selon un autre mode de réalisation, la mémoire selon l'invention est complétée par un deuxième transistor d'accès (TB), dont un drain est connecté au deuxième noeud (B), dont une grille est connectée à la ligne de mot (WL) et dont une source est connectée à une ligne d'écriture (BL) sur laquelle est appliqué un potentiel d'écriture qui est complémentaire du potentiel appliqué sur la ligne de bit. Le deuxième transistor d'accès peut faciliter la programmation du point mémoire car, comme dans une mémoire connue, il n'est pas nécessaire dans ce cas de disposer d'un potentiel actif supérieur au potentiel d'alimentation, comme on le verra mieux par la suite.

L'amplificateur de lecture utilisé est un amplificateur différentiel en courant ou en tension ; il peut être également dissymétrique.

Pour lire un point mémoire d'une mémoire selon l'invention, on précharge la ligne de bits (BLREAD) et la ligne de référence (BLREF) en leur appliquant un potentiel de lecture (VDD) puis :
- on sélectionne un point à lire (Pi) en appliquant un potentiel de sélection (VDD ou GND) sur une ligne de mot (WLi) associée au dit point à lire (Pi),
- on rend flottantes la ligne de bit (BLREAD) et la ligne de référence (BLREF), puis :
   ➢ on détecte une différence entre le courant circulant dans la ligne de lecture et le courant circulant dans la ligne de référence, ou
   ➢ on détecte une différence de potentiel entre le potentiel présent sur la ligne de lecture et le
   potentiel présent sur la ligne de référence.

Le potentiel de sélection a ici une valeur choisie de sorte à rendre passant un transistor d'accès ; selon le mode de réalisation du transistor d'accès, transistor de type N ou de type P par exemple, le potentiel de sélection pourra être égal à VDD, GND, ou tout autre potentiel approprié. De même, la valeur du potentiel appliqué sur la ligne de bit et sur la ligne de référence est indifférente. Il suffit que ce potentiel soit suffisant pour réaliser une lecture du point considéré et que le potentiel soit le même sur la ligne de bit et sur la ligne de référence : cette caractéristique est nécessaire pour mesurer la contribution apportée par les éventuels courants de fuite lors de la lecture, la dite contribution étant ensuite supprimée par différenciation dans l'amplificateur de lecture.

Pour écrire une donnée dans un point mémoire d'une mémoire telle que décrite ci-dessus :
- on sélectionne un point à écrire (Pi) en appliquant un potentiel actif sur une ligne de mot (WLi) associée au dit point à écrire,
- on applique sur la ligne de bit (BLREAD) associée au point à écrire un potentiel de masse ou un potentiel d'alimentation (VDD), selon la donnée à écrire.

Si le point mémoire ne possède pas de deuxième transistor d'accès, le potentiel actif est, selon le type du premier transistor d'accès :
- soit supérieur au potentiel d'alimentation (VDD), et de préférence supérieur à une somme du potentiel d'alimentation (VDD) et d'un potentiel de seuil (VT) du premier transistor d'accès (TAi),
- soit inférieur au potentiel de masse (GND), et de préférence l'opposé (-VT) du potentiel de seuil.

L'invention sera mieux comprise et d'autres caractéristiques et avantages apparaîtront à la lecture de la description qui va suivre, d'un exemple de réalisation d'une mémoire selon l'invention. La description est à lire en relation aux dessins annexés dans lesquels :
- la figure 1, déjà décrite, est un schéma d'un point mémoire SRAM connu,
- la figure 2, déjà décrite, est un schéma d'une rangée de points d'une mémoire SRAM connue,
- la figure 3 est un point mémoire et
- la figure 4 est une rangée de points d'une mémoire selon l'invention.

Sur toutes les figures, des objets ayant la même référence sont identiques. Le chiffre qui termine une référence indique le rang de l'objet en cause. Par exemple, P1 est le point mémoire de rang 1, A1 est le noeud A du point mémoire P1, etc.

Dans un point mémoire (figure 3), par rapport à un point mémoire connu (figure 1), on a remplacé le transistor d'accès TB, connecté au noeud B du point mémoire, par un transistor de référence TC, dont un drain est connecté au noeud A, dont la grille est connectée à la masse et dont la source est connectée à une ligne de référence BLREF, la dite ligne étant portée à un potentiel de référence VREF. Dans l'exemple de la figure 3, VREF = VDD. Si le transistor d'accès TA est de type P, on choisira plutôt VREF = GND. De préférence, les transistors TC et TA sont de même taille.

Dans une mémoire selon l'invention (figure 4), pour former une rangée, on connecte N+1 points mémoire P0, P1, ..., PN réalisés selon le schéma de la figure 3, associés avec un amplificateur de lecture SA', de manière assez similaire à ce qui se fait pour une mémoire connue. Ainsi, tous les transistors d'accès TA0, TA1, ..., TAN ont leur drain connecté à la ligne de bit BLREAD, et tous ont leur grille connectée à une ligne de mot différente, respectivement WL0, WL1, ..., WLN. La ligne de bit BLREAD et la ligne de référence BLREF sont connectées respectivement à l'entrée positive et à l'entrée négative de l'amplificateur différentiel SA'. L'amplificateur SA' est dans l'exemple de la figure 4 un amplificateur différentiel en courant, apte à comparer des courants circulant sur des lignes connectées à ses entrées. On pourrait également utiliser un amplificateur différentiel en tension.

Par ailleurs, selon l'invention, les transistors TC0, TC1, ..., TCN des points mémoire ont tous leur grille connectée à la masse (donc sont toujours bloqués) et leur source est connectée à la ligne BLREF. Les transistors TC0, TC1, ..., TCN sont choisis de préférence identiques respectivement aux transistors TA0, TA1, ..., TAN.

Le fonctionnement d'une mémoire selon l'invention va maintenant être décrit dans le cadre de quelques exemples.

Dans un premier exemple, on suppose que un 0 est programmé dans le point P0 (donc le noeud A0 de P0 est à 0 et le noeud B0 de P0 est à 1) et un 0 est programmé également dans chacun des autres points P1, ..., PN de la rangée de points. Pour lire le point P0, on précharge tout d'abord la ligne BLREAD et la ligne BLREF en leur appliquant un potentiel de lecture VDD, puis :
- on sélectionne le point P0 à lire en appliquant un potentiel de sélection (ici VDD car TA0 est de type N), sur la ligne de mot WL0 associée au point P0 pour rendre passant le transistor TA0, et on applique WL1 = ... = WLN = 0 pour bloquer les transistors d'accès des points P1, ..., PN,
- on rend flottantes la ligne BLREAD et la ligne BLREF puis, selon l'amplificateur SA' utilisé :
   ➢ on détecte une différence entre le courant circulant dans la ligne BLREAD et le courant circulant dans la ligne BLREF, ou
   ➢ on détecte une différence de potentiel entre le potentiel présent sur la ligne BLREAD et le
   potentiel présent sur la ligne BLREF.

Le transistor TA0 voit des potentiels différents aux extrémités de son canal (d'un côté le potentiel 0 au point A0, de l'autre côté le potentiel VDD sur la ligne BLREAD) ; comme TA0 est passant (WL0 = 1), le courant IREAD circule dans TA0. Chacun des N transistors TA1, ..., TAN voit également des potentiels différents aux extrémités de son canal (d'un côté le potentiel 0 au point A1, ..., respectivement AN, de l'autre côté le potentiel VDD sur la ligne BLREAD ; par contre, comme les transistors TA1, ..., TAN sont bloqués (WL1 = ... = WLN = 0), seul un courant IOFF circule dans chaque transistor TA1, ..., TAN. Au final, la ligne BLREAD est déchargée par la somme des courants circulant dans les transistors TA0, TA1, ..., TAN, c'est à dire par le courant IREAD + N*IOFF.

Le transistor TC0 voit quant à lui des potentiels différents aux extrémités de son canal (d'un côté le potentiel 0 au point A0, de l'autre côté le potentiel VDD sur la ligne BLREF) ; comme TC0 est bloqué (sa grille est connectée à la masse GND), le courant IOFF circule dans TC0. Chacun des N transistors TC1, ..., TCN voit également des potentiels différents aux extrémités de son canal (d'un côté le potentiel 0 au point A1, ..., respectivement AN, de l'autre côté le potentiel VDD sur la ligne de référence ; comme les transistors TC1, ..., TCN sont bloqués (leur grille est connectée à la masse), seul un courant IOFF circule dans chaque transistor TC1, ..., TCN. Au final, la ligne BLREF est déchargée par la somme des courants circulant dans les transistors TC0, TC1, ..., TCN, c'est à dire par le courant (N+1)*IOFF.

L'amplificateur de lecture SA' voit ainsi :
- sur son entrée positive, un courant de décharge de la ligne de bit égal à IREAD + N*IOFF,
- sur son entrée de référence, un courant de décharge de la ligne de référence égal à (N+1)*IOFF
   et produit en conséquence un courant ΔI égal à la différence, soit ΔI = IREAD - IOFF.

Dans un deuxième exemple, on suppose que un 0 est programmé dans le point P0 et un 1 est programmé dans chacun des autres points P1 à PN. Pour lire le point P0, on précharge à VDD la ligne BLREAD et la ligne BLREF, puis :
- on applique WL0 = VDD pour sélectionner le point P0 en et on applique WL1 = ... = WLN = 0 pour bloquer les transistors d'accès des points P1, ..., PN,
- on rend flottantes la ligne BLREAD et la ligne BLREF puis, selon l'amplificateur SA' utilisé, on détecte une différence de courant ou de tension entre les lignes BLREAD et BLREF.

Le courant IREAD circule dans TA0 (car A0 est au potentiel 0, BLREAD est au potentiel VDD et TA0 est passant). Chacun des N transistors TA1, ..., TAN voit quant à lui un même potentiel VDD aux extrémités de son canal (d'un côté au point A1, ..., respectivement AN, le potentiel VDD correspondant à un 1 logique, de l'autre côté le potentiel VDD sur la ligne BLREAD), en conséquence aucun courant ne circule dans les transistors TA1, ..., TAN. Au final, la ligne BLREAD est déchargée par la somme des courants circulant dans les transistors TA0, TA1, ..., TAN, c'est-à-dire par le courant IREAD + N*0 = IREAD.

Le courant IOFF circule dans TC0 (car A0 est au potentiel 0, BLREF est au potentiel VDD et TC0 est passant), et aucun courant ne circule dans les transistors TC1, ..., TCN (car les points A1, ..., AN sont au même potentiel VDD que la ligne BLREF). Au final, la ligne BLREF est déchargée par la somme des courants circulant dans les transistors TC0, TC1, ..., TCN, c'est-à-dire par le courant IOFF.

L'amplificateur de lecture SA' voit ainsi :
- sur son entrée positive, un courant de décharge de la ligne de bit égal à IREAD,
- sur son entrée de référence, un courant de décharge de la ligne de référence égal à IOFF
   et produit en conséquence un courant ΔI égal à la différence, soit ΔI = IREAD - IOFF.

Dans un troisième exemple, on suppose que un 1 est programmé dans le point P0 et qu'un 1 est programmé dans chacun des autres points P1 à PN. Pour lire le point P0, on précharge à VDD la ligne BLREAD et la ligne BLREF, puis :
- on applique WL0 = VDD, WL1 = ... = WLN = 0,
- on rend flottantes la ligne BLREAD et la ligne BLREF puis, selon l'amplificateur SA' utilisé, on détecte une différence de courant ou de tension entre les lignes BLREAD et BLREF.

Aucun courant ne circule dans TA0, car A0 est au potentiel VDD, BLREAD est au potentiel VDD et TA0 est passant. Aucun courant ne circule non plus dans TA1, ..., TAN, car les points A1, ..., AN sont au potentiel VDD et la ligne BLREAD également. Au final, la ligne BLREAD est déchargée par un courant égal à 0. De même, aucun courant ne circule dans TC0, car A0 est au potentiel VDD et BLREAD également. Aucun courant ne circule non plus dans TC1, ..., TCN, car les points A1, ..., AN sont au potentiel VDD et la ligne BLREF également. Au final, la ligne BLREF est déchargée par un courant égal à 0. L'amplificateur SA' voit ainsi des courants nuls sur ses deux entrées et produit en conséquence un courant ΔI égal à 0.

Dans un quatrième exemple, on suppose que un 1 est programmé dans le point P0 et qu'un 0 est programmé dans chacun des autres points P1, ..., PN. Pour lire P0, on précharge à VDD la ligne BLREAD et la ligne BLREF, puis :
- on applique WL0 = VDD, WL1 = ... = WLN = 0,
- on rend flottantes la ligne BLREAD et la ligne BLREF puis, selon l'amplificateur SA' utilisé, on détecte une différence de courant ou de tension entre les lignes BLREAD et BLREF.

Aucun courant ne circule dans TA0, car A0 est au potentiel VDD, BLREAD est au potentiel VDD et TA0 est passant. Par contre, un courant IOFF circule dans chacun des N transistors TA1, ...TAN car les points A1, ..., AN sont au potentiel 0 et la ligne BLREAD au potentiel VDD. Au final, la ligne BLREAD est déchargée par un courant égal à 0 + N*IOFF. De même, aucun courant ne circule dans TC0, car A0 est au potentiel VDD et BLREAD également. Par contre un courant IOFF circule dans chacun des transistors TC1, ..., TCN car les points A1, ..., AN sont au potentiel 0 et la ligne BLREF est à au potentiel VDD. Au final, la ligne BLREF est déchargée par un courant égal à 0 + N*IOFF.

L'amplificateur voit ainsi :
- sur son entrée positive, un courant de décharge de la ligne BLREAD égal à (N)*IOFF,
- sur son entrée de référence, un courant de décharge de la ligne BLREF égal à (N)*IOFF
   et produit en conséquence un courant ΔI égal à la différence, soit ΔI = 0.

Le tableau ci-dessous résume les quatre exemples extrêmes décrits ci-dessus. La première colonne indique le potentiel au point A0, qui correspond à la donnée à lire ; la deuxième colonne indique le potentiel aux points P1 à PN ; la troisième colonne et la quatrième colonne indiquent les courants de décharge de la ligne de bit et de la ligne de référence ; et la cinquième colonne indique le courant produit par l'amplificateur SA', qui correspond à la donnée lue par l'amplificateur SA'.

| A0 | Ai, pour i ≠ 0 | BLREAD | BLREF | ΔI |
|---|---|---|---|---|
| VDD | VDD | 0 + 0 | 0 + | 0 |
| VDD | 0 | 0 + N*IOFF | 0 + N*IOFF | 0 |
| 0 | VDD | IREAD + 0 | IOFF | IREAD - IOFF |
| 0 | 0 | IREAD + N*IOFF | IOFF + N*IOFF | IREAD - IOFF |

On voit clairement dans la 5^{ème} colonne que le courant lu ΔI est indépendant de N, contrairement aux cas des mémoires SRAM connues : le courant ΔI est ainsi indépendant du nombre de points mémoire présents dans la rangée, ou plus précisément du nombre N de transistors TA qui, lors d'une lecture d'un point de la rangée, voient des potentiels différents aux extrémités de leur canal et qui fuient lorsqu'ils sont bloqués.

Le fait que dans une mémoire selon l'invention, le courant de lecture soit indépendant du nombre de points est du au fait que les fuites de courant dans certains transistors TA sont compensées par des fuites de courant de même quantité dans les transistors TC correspondants. La lecture d'un point est donc toujours réalisable et le nombre de points associés à un amplificateur dans une même rangée n'est plus limité.

Pour programmer un point mémoire, il suffit d'appliquer le potentiel souhaité sur la ligne BLREAD (0 ou VDD selon la valeur à programmer au point Ai) et d'appliquer sur la ligne de mot WLi souhaitée un potentiel supérieur ou égal à VDD + VT, VT étant un seuil de saturation du transistor TAi. Ce potentiel élevé VDD + VT est nécessaire pour rendre passant le transistor N de l'inverseur IA, en particulier dans le cas où on souhaite mémoriser la valeur 1 dans un point mémoire contenant précédemment la valeur 0. En effet, un transistor de type N, ici le transistor TAi, est passant uniquement si on a une différence de potentiel entre son drain (le point Ai) et sa grille supérieure à une tension VT de seuil de conduction du transistor. Dit autrement, pour programmer le point Pi, si on applique VDD sur la grille du transistor TAi, on pourra au mieux atteindre VDD - VT au point Ai. Il faut donc appliquer VDD + VT sur la grille de TAi pour obtenir VDD au point Ai en fin de programmation. Un raisonnement similaire doit être tenu dans le cas où le transistor d'accès TAi utilisé est de type P et où on souhaite mémoriser un 0 dans un point mémoire contenant précédemment un 1 logique. Si on applique GND sur la grille d'un transistor P et GND sur sa source, on pourra au mieux atteindre VT sur son drain. Il faut appliquer -VT sur sa grille pour atteindre GND (0) sur son drain.

Appliquer VDD+VT (ou -VT selon le cas) sur la grille de Tai est certes une solution efficace, mais elle présente l'inconvénient de nécessiter la présence d'un circuit élévateur de potentiel (ou abaisseur de potentiel, selon le cas), par exemple du type pompe de charge, afin d'élever le potentiel d'alimentation VDD à VDD+VT (ou d'abaisser GND à -VT). Ceci augmente de 5 à 10% la taille de la mémoire, et surtout, ceci augmente fortement la complexité du circuit du fait de la complexité de la mise au point d'une pompe de charge.

Pour faciliter la programmation d'un point mémoire, il est également possible, comme par le passé, d'ajouter un transistor d'accès TB (représenté en pointillés sur la figure 3), dont un drain est connecté au noeud B du point mémoire, dont la source est connectée à une ligne de programmation BLF (sur laquelle on applique un potentiel complémentaire du potentiel appliqué sur la ligne BLREAD) et dont la grille est connectée à la même ligne de mot que le transistor TA pour permettre la sélection du point.

Dans l'exemple de la figure 4, un amplificateur différentiel en courant a été utilisé. Il est également possible d'utiliser un amplificateur différentiel en tension, qui compare lors d'une lecture la différence de potentiel entre la ligne BLREAD et la ligne BLREF. Un tel amplificateur produit dans ce cas en sortie une tension ΔV qui peut prendre deux valeurs, 0 ou VS, VS étant une tension indépendante du nombre N de points mémoire dans une rangée.

Egalement, dans l'invention, l'amplificateur utilisé est un amplificateur dissymétrique. En effet, de par la construction d'une mémoire selon l'invention, lors d'une lecture, le courant circulant dans la ligne BLREAD est toujours supérieur au courant circulant dans la ligne BLREF et le potentiel sur la ligne BLREAD est toujours inférieur au potentiel sur ligne BLREF, quelle que soit la valeur 0 ou 1 mémorisée dans le point lu.

## Revendications

1. Mémoire comportant une rangée comprenant
• un ensemble de points mémoire, chaque point mémoire comprenant un premier inverseur (IA) et un deuxième, inverser (IB) connectées tête-bêche entre un premier noeud (A) et un deuxième noeud (B), et un premier transistor d'accès (TA) dont un drain est connecté au premier noeud (A), le premier transistor d'accès (TA) de chaque point mémoire ayant une grille connectée à une ligne de mot (WL0, WL1, WLN) associée au dit point mémoire, et une source connectée à une unique ligne de bit (BLREAD), et
• un amplificateur de lecture (SA'), la ligne de bit étant connectée à une première entrée de l'amplificateur,
chaque point mémoire comprenant également un transistor de référence (TC) dont un drain est connecté au premier noeud (A), un même potentiel de blocage étant appliqué sur la grille du transistor de référence (TC) de chaque point mémoire pour bloquer le transistor de référence (TC), **caractérisée en ce qu'**une source du transistor de référence (TC) est connectée à une unique ligne de référence (BLREF), la ligne de référence (BLREF) étant connectée à une deuxième entrée de l'amplificateur de lecture.

2. Mémoire selon la revendication 1, dans laquelle chaque point mémoire comporte également un deuxième transistor d'accès (TB), dont un drain est connecté au deuxième noeud (B), dont une grille est connectée à la ligne de mot (WL) respective et dont une source est connectée à une ligne d'écriture (BLF) sur laquelle est appliqué un potentiel d'écriture qui est complémentaire du potentiel appliqué sur la ligne de bit (BLREAD).

3. Mémoire selon la revendication 1, comprenant également un moyen pour appliquer sur l'une des lignes de mot (WL) choisie un potentiel actif qui est :
• soit (VDD+VT) supérieur à un potentiel d'alimentation (VDD), si le premier transistor d'accès est d'un premier type (type N),
• soit (- VT) inférieur à un potentiel de masse (GND), si le premier transistor d'accès est d'un deuxième type (type P).

4. Mémoire selon la revendication 1, dans laquelle l'amplificateur de lecture (SA') est un amplificateur différentiel en courant ou en tension.

5. Mémoire selon la revendication précédente, dans laquelle l'amplificateur de lecture (SA') est un amplificateur dissymétrique.

6. Procédé de lecture d'un point mémoire d'une mémoire selon la revendication 3, procédé au cours duquel on précharge la ligne de bit (BLREAD) et la ligne de référence (BLREF) en leur appliquant un potentiel de lecture (VDD), puis :
• on sélectionne un point à lire (Pi) en appliquant un potentiel de sélection (VDD ou GND) sur une ligne de mot (WLi) associée au dit point à lire (Pi),
• on rend flottantes la ligne de bit (BLREAD) et la ligne de référence (BLREF) puis :
➢ on détecte une différence entre le courant circulant dans la ligne de lecture et le courant circulant dans la ligne de référence, ou
➢ on détecte une différence de potentiel entre le potentiel présent sur la ligne de lecture et le potentiel présent sur la ligne de référence.

7. Procédé d'écriture d'une donnée dans un point mémoire d'une mémoire selon l'une des revendications 1 à 5, procédé au cours duquel :
• on sélectionne un point à écrire (Pi) en appliquant un potentiel actif sur une ligne de mot (WLi) associée au dit point à écrire (Pi)
• on applique sur la ligne de bit (BLREAD) associée au point à écrire un potentiel de masse ou un potentiel d'alimentation (VDD), selon la donnée à écrire.

8. Procédé selon la revendication précédente lorsqu'elle est combinée à la revendication 3, dans lequel le potentiel actif est supérieur au potentiel d'alimentation (VDD) ou inférieur au potentiel de masse (GND), selon le type du premier transistor d'accès (TAi).

9. Procédé selon la revendication précédente, dans lequel le potentiel actif est, selon le type du premier transistor d'accès (TAi) .
• soit supérieur à une somme du potentiel d'alimentation (VDD) et d'un potentiel de seuil (VT) du premier transistor d'accès (TAi),
• soit l'opposé (-VT) du potentiel de seuil.

10. Procédé selon la revendication 7 lorsqu'elle est combinée avec la revendication 2, au cours duquel on applique simultanément sur la grille du premier transistor d'accès et du deuxième transistor d'accès du point mémoire à écrire un potentiel actif égal au potentiel d'alimentation (VDD) ou au potentiel de masse, selon le type du premier transistor d'accès.

## Claims

1. A single row memory comprising:
- a set of memory cells, where each memory cell comprises a first inverter (IA) and a second inverter (IB) connected upside down to each other between a first node (A) and a second node (B), and a first access transistor (TA) having a drain connected to the first node (A), with the first access transistor (TA) of each memory cell having a gate connected to a word line (WLO, WL1, ..., WLN) assigned to said memory cell and a source connected to a single bit line (BLREAD), and
- a read amplifier (SA'), with the bit line connected to a first input to the amplifier,
with each memory cell also comprising a reference transistor (TC) having a drain connected to the first node (A), a same cut-off potential being applied to the reference transistor (TC) gate for each memory cell so as to cut-off the reference transistor (TC), **characterized by** a reference transistor (TC) source that is connected to a single reference line (BLREF), this reference line (BLREF) being connected to a second input to the read amplifier.

2. A memory according to claim 1, wherein each memory cell also comprises a second access transistor (TB), having a drain connected to the second node (B), a gate connected to the respective word line (WL) and a source connected to a write line (BLF) to which is applied a write potential that is complementary to the potential applied to the bit line (BLREAD).

3. A memory according to claim 1, also comprising a means for the application to one of the chosen word lines (WL), of an active potential which is:
• either (VDD+VT) greater than a power supply potential (VDD), if the first access transistor is of a first type (type N),
• or (- VT) below a ground potential (GND), if the first access transistor is of a second type (type P).

4. A memory according to claim 1, wherein the read amplifier (SA') is a current or voltage differential amplifier.

5. A memory according to the above claim, wherein the read amplifier (SA') is a dissymmetrical amplifier.

6. A method for the reading of a memory cell in a memory according to claim 3, wherein the bit line (BLREAD) and the reference line (BLREF) are pre-charged by the application to them of a read potential (VDD) then:
• the cell to be read (Pi) is selected by the application of a selection potential (VDD or GND) to a word line (WLi) associated with said cell to be read (Pi),
• the bit line (BLREAD) and the reference line (BLREF) are made floating, and then:
• a difference is detected in the current flowing in the read line and the current flowing in the reference line, or
• a potential difference is detected between the potential present on the read line and the potential present on the reference line.

7. A method for writing a piece of data to a memory cell in a memory according to one of the claims 1 to 5, wherein :
• a cell (Pi) to be written is selected by the application of an active potential to a word line (WLi) associated with said cell to be written (Pi),
• a ground potential or a power supply potential (VDD) is applied to the bit line (BLREAD) associated with the cell to be written to, according to the data to be written.

8. A method according to the above claim, combined with claim 3, wherein the active potential is greater than the power supply potential (VDD) or below the ground potential (GND), according to the type of first access transistor (TAi).

9. A process according to the above claim wherein, depending on the type of first access transistor (TAi), the active potential is:
• either greater than a sum of a power supply potential (VDD) and a threshold potential (VT) of the first access transistor (TAi),
• or the opposite (-VT) of the threshold potential.

10. A method according to claim 7 when combined with claim 2, wherein an active potential equal to the power supply potential (VDD) or to the ground potential, according to the type of first access transistor, is applied simultaneously to the gate of the first and second access transistor to the memory cell to be written.

## Patentansprüche

1. Speicher mit einer Reihe, die umfasst
- eine Gesamtheit von Speicherpunkten, wobei jeder Speicherpunkt einen ersten Inverter (IA) und einen zweiten Inverter (IB) umfasst, die rückgekoppelt sind zwischen einem ersten Knoten (A) und einem zweiten Knoten (B), und einen ersten Zugriffstransistor (TA), dessen Drain mit dem ersten Knoten (A) gekoppelt ist, wobei der erste Zugriffstransistor (TA) jedes Speicherpunktes ein Gate hat, das mit einer Wortleitung (WLO, WL1, WLN) verbunden ist, die diesem Speicherpunkt zugeordnet ist, und eine mit einer einzigen Bitleitung (BLREAD) verbundene Quelle, und
- einen Leseverstärker (SA'), wobei die Bitleitung mit einem ersten Eingang des Verstärkers verbunden ist,
wobei jeder Speicherpunkt auch einen Bezugstransistor (TC) umfasst, dessen Drain mit dem ersten Knoten (A) gekoppelt ist, wobei eine gleiche Sperrspannung an das Gate des Bezugstransistors (TC) jedes Speicherpunktes gelegt wird, um den Bezugstransistor (TC) zu sperren, **dadurch gekennzeichnet, dass** eine Quelle des Bezugstransistors (TC) mit einer einzigen Bezugsbitleitung (BLREF) verbunden ist, wobei die Bezugsbitleitung (BLREF) mit einem zweiten Eingang des Leseverstärkers verbunden ist.

2. Speicher nach Anspruch 1, wobei jeder Speicherpunkt auch einen zweiten Zugriffstransistor (TB) umfasst, dessen Drain mit dem zweiten Knoten (B) gekoppelt ist, wobei ein Gate mit der entsprechenden Wortleitung (WL) gekoppelt und eine Quelle mit einer Schreibleitung (BLF) verbunden ist, an die eine Schreibspannung gelegt wird, die zu der an die Bitleitung (BLREAD) gelegten Spannung komplementär ist.

3. Speicher nach Anspruch 1, der auch ein Mittel umfasst, um an eine ausgewählte Wortleitung (WL) eine aktive Spannung zu legen, die
- entweder (VDD+VT) größer ist als eine Versorgungsspannung (VDD), wenn der erste Zugriffstransistor ein Transistor des ersten Typs ist (Typ N),
- oder (- VT) kleiner ist als eine Massespannung (GND), wenn der erste Zugriffstransistor ein Transistor des zweiten Typs ist (Typ P).

4. Speicher nach Anspruch 1, wobei der Leseverstärker (SA') ein Strom- oder ein Spannungsdifferenzverstärker ist.

5. Speicher nach Anspruch 1, wobei der Leseverstärker (SA') ein asymmetrischer Verstärker ist.

6. Verfahren zum Lesen eines Speicherpunktes eines Speichers nach Anspruch 3, in dessen Verlauf die Bitleitung (BLREAD) und die Bezugsbitleitung (BLREF) durch Anlegen einer Lesespannung (VDD) vorgeladen wird, und dann
- ein zu lesender Punkt (Pi) ausgewählt wird, durch Anlegen einer Auswahlspannung (VDD oder GND) an eine Wortleitung (WLi), die diesem zu lesenden Punkt (Pi) zugeordnet ist,
- die Bitleitung (BLREAD) und die Bezugsbitleitung (BLREF) floatend geschaltet wird, und dann
- eine Differenz erkannt wird zwischen dem Strom, der durch die Leseleitung fließt und dem Strom, der durch die Bezugsleitung fließt, oder
- eine Spannungsdifferenz erkannt wird zwischen der Spannung, die an der Leseleitung liegt und der Spannung, die an der Bezugsleitung liegt.

7. Verfahren zum Schreiben einer Information in einen Speicherpunkt eines Speichers nach einem der Ansprüche 1 bis 5, in dessen Verlauf
- ein zu beschreibender Punkt (Pi) ausgewählt wird, durch Anlegen einer aktiven Spannung an eine Wortleitung (WLi), die diesem zu beschreibenden Punkt (Pi) zugeordnet ist,
- an die Bitleitung (BLREAD), die dem zu beschreibenden Punkt zugeordnet ist, eine Massespannung oder eine Versorgungsspannung (VDD) gelegt wird, je nach der Information, die geschrieben werden soll.

8. Verfahren nach dem vorhergehenden Anspruch, wenn dieser mit Anspruch 3 verbunden ist, wobei die aktive Spannung größer ist, als die Versorgungsspannung (VDD) oder kleiner, als die Massespannung (GND), je nach dem Typ des ersten Zugriffstransistors (TAi).

9. Verfahren nach dem vorhergehenden Anspruch, wobei die aktive Spannung, je nach dem Typ des ersten Zugriffstransistors (TAi),
- entweder größer ist, als eine Summe der Versorgungsspannung (VDD) und einer Schwellenspannung (VT) des ersten Zugriffstransistors (TAi),
- oder die umgekehrte Spannung (-VT) der Schwellenspannung ist.

10. Verfahren nach Anspruch 7, wenn dieser mit Anspruch 2 verbunden ist, in dessen Verlauf an das Gate des ersten Zugriffstransistors und des zweiten Zugriffstransistors des Speicherpunktes, der zu beschreiben ist, eine aktive Spannung gelegt wird, die gleich der Versorgungsspannung (VDD) oder der Massespannung ist, je nach dem Typ des ersten Zugriffstransistors.
